# EUROPEAN PATENT APPLICATION

(11) **EP 2 709 150 A1**
(43) Date of publication of application: **19.03.2014**
(21) Application number: 12184862.6
(22) Date of filing: 18.09.2012
(51) Int. Cl.: H01L 23/24, H01L 23/00

(54) **Humidity protection of semiconductor modules**

(71) Applicant: ABB Technology AG, 8050 Zürich (CH)
(72) Inventor: Schnell, Raffael, 5703 Seon (CH)
(74) Representative: ABB Patent Attorneys

(57) **Abstract**

The present invention provides semiconductor module (1) comprising a housing (2), a substrate (6) with at least one semiconductor (12, 13) mounted thereon, whereby the substrate (6) is held in the housing (2), and a covering material (18) covering the at least one semiconductor (12, 13) on the substrate (6), wherein a vapor barrier (19) is provided around the covering material (18).

## Description

### Technical Field

The present invention relates to a semiconductor module comprising a housing, a substrate with at least one semiconductor mounted thereon, whereby the substrate is held in the housing, and a covering material covering the at least one semiconductor on the substrate.

### Background Art

These semiconductor modules use covering material, typically silicone gel in order to protect the semiconductors, possible other electronic components and its connections from environmental impact such as humidity. In addition the covering material provides greater dielectric insulation properties than plain air, allowing shorter insulation distances and thus compacter semiconductor modules.

Power semiconductor modules are used in high power applications to switch high voltages and currents and usually comprise multiple power semiconductors. Since each single semiconductor has a maximum voltage and current, the power semiconductors are combined in parallel and/or in series within the power semiconductor modules to enable the use in high power applications. The substrates are provided with common contacts for emitter, collector and base, so that the substrates can easily be connected within the power semiconductor modules. The substrate is typically mounted on a base plate, which can be part of a housing of the power semiconductor module. Alternatively, the power semiconductor module can comprise a cooler, and the substrate can be directly mounted to the cooler. Accordingly, the cooler can be a part of the housing of the power semiconductor module.

In nowadays power semiconductor modules, the substrates are typically provided with one or more semiconductors comprising power transistors like insulated gate bipolar transistors (IGBT) or reverse conducting insulated gate bipolar transistors (RC-IGBT), power diodes, or other power semiconductors suitable for high power applications

Humidity inside semiconductor modules is a known cause of failures. Semiconductor modules operated in environments with high humidity suffer from diffusion of the humidity into the module, mainly into the covering material. The problem is increased in semiconductor modules, which generate big amounts of heat in operation, like the aforementioned power semiconductor modules. Accordingly, the temperature inside the semiconductor module and in particular the temperature of the semiconductors can vary between different operational states, e.g. between an "on" and an "off" state. Furthermore, power semiconductor modules are frequently connected to an active cooling, i.e. a cooler, in order to remove heat generated by operational losses of its power semiconductors. The cooler can be integral part of the housing as stated above, or it can be connected to the housing, preferably to the base plate. If the power semiconductor modules are operated at low load conditions, the temperature of the semiconductors and the base plate including the surface can drop several tenths of Kelvin compared to full load condition. Such changes of temperature can lead to dewing or condensation of humidity on a surface of the semiconductor and/or on the surface of the substrate, if the humidity in the covering material is high enough. The dewing or condensation on the semiconductor and/or on the substrate surface can lead to the formation of a wet-film, and an electrolytic surface current can be the result, if a voltage is applied to the semiconductor module.

### Disclosure of Invention

It is an object of the present invention to provide a semiconductor module with an increased humidity protection. In particular, it is an object of the present invention to provide a semiconductor module with reduced sufferings from effects like dewing or condensation of humidity on surfaces of the at least one semiconductor.

This object is achieved by the independent claim. Advantageous embodiments are given in the dependent claims.

In particular, the present invention provides a semiconductor module comprising a housing, a substrate with at least one semiconductor mounted thereon, whereby the substrate is held in the housing, and a covering material covering the at least one semiconductor on the substrate, whereby a vapor barrier is provided around the covering material.

The basic idea of the invention is to use the vapor barrier to avoid humidity from passing into the covering material, so that dewing and condensation of humidity on a surface of the semiconductor and/or the substrate can be avoided. It is preferred that the covering material is provided with low humidity when the semiconductor module is manufactured, so that even under disadvantageous ambient and/or operational conditions the risk of dewing and condensation is reduced.

Depending on the design of the semiconductor module and the placement of the substrate and the covering material therein, the vapor barrier can be provided differently. If the covering material is only provided on top of the substrate, the vapor barrier can be connected to the substrate and extend around the covering material on top of the substrate. Depending in particular on the placement of the covering material and the substrate, the vapor barrier can encircle the entire substrate with the semiconductors mounted thereon. The covering material is typically silicone gel or a potting material.

According to a modified embodiment the vapor barrier has an increased diffusion resistance for low relative humidity compared to the diffusion resistance for increased relative humidity. This vapor barrier first prevents the covering material from accumulating humidity, which might dew or condensate on a surface of the semiconductor. Second, this vapor barrier enables that humidity is removed from the covering material, when the relative humidity on the side of the covering material is higher than the relative humidity on the opposite side of the vapor barrier. Accordingly, long term accumulation of humidity in the covering material can be reduced or even avoided.

According to a modified embodiment the vapor barrier is chosen from at least one of expanded PTFE, Gore-Tex Standard, SympaTex Laminate, Mountain Hardware "Conduit", Schoeller WB-Formula, The North Face "Hydroseal", Marmot "Membrain", Today Industries "Entrant Dermizax", or GoreTex XCR. The mentioned materials, which are usually known from the area of outdoor clothing, have reliable characteristics for an increased diffusion resistance for low relative humidity compared to the diffusion resistance for increased relative humidity. Furthermore, these materials are suitable for application in semiconductor modules.

According to a modified embodiment the covering material is filled in the housing covering the at least one semiconductor on the substrate, and the vapor barrier comprises a first barrier part extending between walls of the housing. The first barrier part separates an inner space of the housing to provide a vapor barrier between the part of the inner space containing the covering material and the other, outer part, thereby preventing accumulation of humidity from the outer part in the covering material. The walls can refer to any kind of wall of the housing including bottom, side and top walls. For example, the first barrier part can extend between two side walls and the bottom wall.

According to a modified embodiment the first barrier part is provided as a sealing of a part of the housing, where the substrate with at least one semiconductor and the covering material are located. The sealing refers to a separation of the inner part of the housing into a part, where the substrate with at least one semiconductor and the covering material are located, and the remainder part of the inner part of the housing. The sealing can be provided in a separate production step independently from the mounting of the substrate and the covering material. Preferably, the sealing is provided after the substrate with the semiconductors and the covering material are arranged in the housing.

According to a modified embodiment the vapor barrier comprises a second barrier part provided internally at walls of the housing. The second barrier part provides a protection of the covering material from the walls, in case humidity might enter through the walls or joints of the walls. Application of the vapor barrier is facilitated by the second barrier part, since it can be applied to the walls of the housing prior to filling the covering material in the housing. Accordingly, the vapor barrier does not have to be applied separately to the covering material in the area of the walls of the housing. The walls can be any kind of wall of the housing, including upper, lower and side walls. Preferably, the second barrier part is applied to the side wall and the bottom wall of the housing.

According to a modified embodiment the second barrier part is provided as a jetted layer at the walls of the housing. Jetting refers to a technique where a liquid vapor barrier material is provided for forming the vapor barrier after drying. In particular, small amounts of the liquid vapor barrier material are jetted onto the walls of the housing, forming thereon a vapor barrier layer after drying. This technique is similar to an application process used in inkjet printers.

According to a modified embodiment the vapor barrier is provided at least partially in direct contact with the covering material. Therefore, humidity can be directly transferred between the covering material and the medium on the other side of the vapor barrier, which is typically air. The transfer of humidity out of the covering material can be realized directly, without the necessity to transfer the humidity first to a further medium, typically air, and from the further medium through the vapor barrier. Accordingly, the humidity transfer out of the covering material is improved.

According to a modified embodiment the vapor barrier is provided at least partially as a depositing layer on the covering material. This enables an easy provisioning of the vapor barrier.

According to a modified embodiment the depositing layer is provided as a vapor deposition layer. Vapor deposition is a technique, which is in general known in the art and which facilitates the provisioning of the vapor barrier. It can be applied to different kinds of surfaces, e.g. directly on the covering material as well as on walls of the housing.

According to a modified embodiment the depositing layer is provided as a low temperature plasma coating. Low temperature plasma coating is a technique, which is in general known in the art and which facilitates the provisioning of the vapor barrier. It can be applied to different kinds of surfaces, e.g. directly on the covering material as well as on walls of the housing.

According to a modified embodiment the at least one semiconductor is a power semiconductor. Accordingly, the semiconductor module is a power semiconductor module, which in general suffer more frequently from the effects of dewing or condensation of humidity on surfaces of the at least one semiconductor. Therefore, the power semiconductor module benefits more from the advantages achieved by the provisioning of the vapor barrier around the covering material.

### Brief Description of Drawings

These and other aspects of the invention will be apparent from and elucidated with reference to the embodiments described hereinafter.

In the drawings:

Fig. 1 shows a schematic view of a power semiconductor module according to a preferred embodiment with a cooler connected thereto,

Fig. 2 shows a vapor throughput diagram of a vapor barrier for two different materials depending on the difference of the relative humidity on both sides of the vapor barrier, and

Fig. 3 shows a comparative diagram of relative humidity in the cover material over time with and without a vapor barrier

### Detailed Description of the Invention

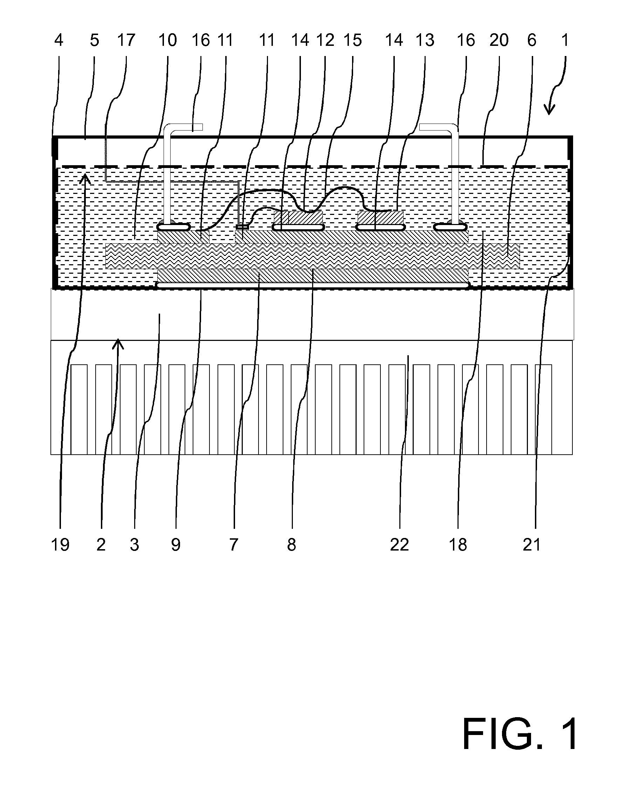

Fig. 1 shows a semiconductor module 1 according to a preferred embodiment of the invention. The semiconductor module 1 comprises a housing 2 with a base plate 3 as bottom wall, side walls 4, and a top wall 5.

The semiconductor module 1 further comprises a substrate 6, which is provided in the housing 2. The substrate 6 is soldered with a ground metallization 7 on its lower surface 8 via a large area soldering joint 9 onto the base plate 3. The ground metallization 7 and therefore large area soldering joint 9 extend over essentially the entire lower surface 8 of the substrate 6. In an alternative embodiment, the substrate 6 is bonded onto the ground metallization 7. In further alternative embodiments, the substrate 6 is fixed to the ground metallization 7 by other joining techniques. Accordingly, the large area soldering joint 9 can be substituted in the alternative embodiments by other connections, e.g. a low temperature joint, a bonding joint, a brazing joint, or a welding joint.

The substrate 6 is provided on its upper surface 10 with metallizations 11, and has multiple power semiconductors 12, 13, from which insulated gate bipolar transistor 12 (IGBT) and power diode 13 are visible in Fig. 1, mounted thereon via soldering joints 14. Bonding wires 15 are provided for connecting the power semiconductors 12, 13 to the metallizations 11. Contact pins 16 are soldered to the metallizations 11 for providing collector and an emitter contacts of the power semiconductor module 1, and an auxiliary contact 17 is provided as a base contact.

The housing 2 is partially filled with a covering material 18 covering the substrate 6 including the power semiconductors 12, 13 and the bonding wires 15. The covering material 18 in this embodiment is a silicon gel. In an alternative embodiment, alternative potting material is used as covering material 18.

A vapor barrier 19 is provided around the covering material 18. The vapor barrier 19 comprises a first barrier part 20 extending between the side walls 4 of the housing 2, and a second barrier part 21 provided internally at the side walls 4 and the base plate 3. First and second barrier part 20, 21 form continuous barrier, whereby the first barrier part 20 provides a sealing of the inner part of the housing 2 containing the covering material 18, the substrate 6 and the power semiconductors 12, 13, and separates this part from the remainder part of the housing 2.

The second barrier part 21 is provided as a jetted layer internally at the side walls 4 and the base plate 3 of the housing 2. The first barrier part 20 is provided as a depositing layer on the covering material 18. In particular, the first barrier part 20 is provided as a vapor deposition layer. In an alternative embodiment, the first barrier part 20 is provided as a low temperature plasma coating. Accordingly, the vapor barrier 19 is in direct contact with the covering material 18.

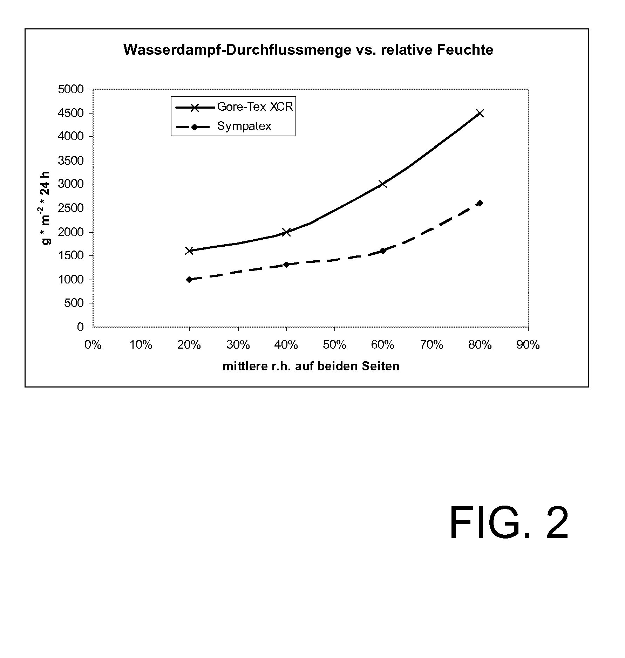

In this embodiment GoreTex XCR is chosen as material for the vapor barrier 19. Accordingly, the vapor barrier 19 has an increased diffusion resistance for low relative humidity compared to the diffusion resistance for increased relative humidity, as can be seen in Fig. 2. The diffusion resistance is calculated as inverse value of the vapor throughput, which is illustrated in Fig. 2 for GoreTex XCR and Sympatex.

In alternative embodiments, expanded PTFE, Gore-Tex Standard, SympaTex Laminate, Mountain Hardware "Conduit", Schoeller WB-Formula, The North Face "Hydroseal", Marmot "Membrain", Today Industries "Entrant Dermizax" or combinations thereof can be chosen as material for the vapor barrier.

The power semiconductor module 1 of the preferred embodiment is coupled to a cooler 22. The cooler 22 is fixed to the base plate 3 and thermally coupled thereto.

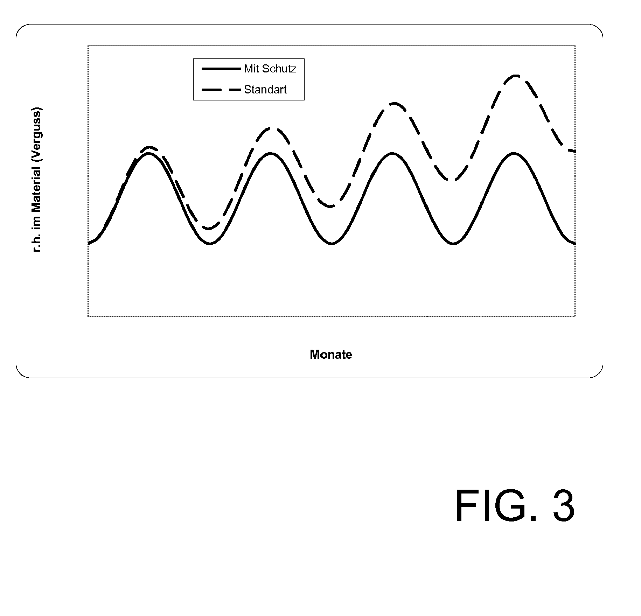

Fig. 3 illustrates the long term effect of the vapor barrier 19. The continuous line represents the humidity of the covering material 18 over the time with the vapor barrier 19 present around the covering material, whereas the dashed line represents the humidity of the covering material 18 without vapor barrier 19. Due to cyclic changes of ambient conditions, both curves show peaks of increased humidity. Nevertheless, with the vapor barrier 19, the humidity of the covering material 18 decreases to initial values after each peak. In contrast, without the vapor barrier 19, a continuous increase of humidity in the covering material 18 can be observed.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: power semiconductor module
- 2: housing
- 3: base plate
- 4: side wall
- 5: top wall
- 6: substrate
- 7: ground metallization
- 8: lower surface
- 9: large area soldering joint
- 10: upper surface
- 11: metallization
- 12: power semiconductor, IGBT
- 13: power semiconductor, power diode
- 14: soldering joint
- 15: bonding wire
- 16: contact pin
- 17: auxiliary pin
- 18: covering material
- 19: vapor barrier
- 20: first barrier part
- 21: second barrier part
- 22: cooler

## Claims

1. Semiconductor module (1) comprising
a housing (2),
a substrate (6) with at least one semiconductor (12, 13) mounted thereon, whereby the substrate (6) is held in the housing (2), and
a covering material (18) covering the at least one semiconductor (12, 13) on the substrate (6),
**characterized in that**
a vapor barrier (19) is provided around the covering material (18).

2. Semiconductor module (1) according to claim 1,
**characterized in that**
the vapor barrier (19) has an increased diffusion resistance for low relative humidity compared to the diffusion resistance for increased relative humidity.

3. Semiconductor module (1) according to claim 2,
**characterized in that**
the vapor barrier (19) is chosen from at least one of expanded PTFE, Gore-Tex Standard, SympaTex Laminate, Mountain Hardware "Conduit", Schoeller WB-Formula, The North Face "Hydroseal", Marmot "Membrain", Today Industries "Entrant Dermizax", or GoreTex XCR.

4. Semiconductor module (1) according to any preceding claim,
**characterized in that**
the covering material (18) is filled in the housing (2) covering the at least one semiconductor (12, 13) on the substrate (6), and
the vapor barrier (19) comprises a first barrier part (20) extending between walls (3, 4, 5) of the housing (2).

5. Semiconductor module (1) according to preceding claim 4,
**characterized in that**
the first barrier part (20) is provided as a sealing of a part of the housing (2), where the substrate (6) with at least one semiconductor (12, 13) and the covering material (18) are located.

6. Semiconductor module (1) according to any preceding claim,
**characterized in that**
the vapor barrier (19) comprises a second barrier part (21) provided internally at walls (3, 4, 5) of the housing (2).

7. Semiconductor module (1) according to preceding claim 6,
**characterized in that**
the second barrier part (21) is provided as a jetted layer at the walls (3, 4, 5) of the housing (2).

8. Semiconductor module (1) according to any preceding claim,
**characterized in that**
the vapor barrier (19) is provided at least partially in direct contact with the covering material (18).

9. Semiconductor module (1) according to preceding claim 8,
**characterized in that**
the vapor barrier (19) is provided at least partially as a depositing layer on the covering material (18).

10. Semiconductor module (1) according to preceding claim 9,
**characterized in that**
the depositing layer is provided as a vapor deposition layer.

11. Semiconductor module (1) according to preceding claim 9,
**characterized in that**
the depositing layer is provided as a low temperature plasma coating.

12. Semiconductor module (1) according to any preceding claim,
**characterized in that**
the at least one semiconductor (12, 13) is a power semiconductor and the semiconductor module (1) is a power semiconductor module.

13. Semiconductor module (1) according to any preceding claim,
**characterized in that**
the covering material (18) is a silicone gel or a potting material.
